# EUROPEAN PATENT SPECIFICATION

(11) **EP 3 545 560 B1**
(45) Date of publication and mention of the grant of the patent: **19.08.2020**
(21) Application number: 17817125.2
(22) Date of filing: 20.11.2017
(51) Int. Cl.: H01L 31/054

(54) **PHOTOVOLTAIC MODULE**
FOTOVOLTAISCHES MODUL
MODULE PHOTOVOLTAÏQUE

(30) Priority: 23.11.2016 IT 201600118604
(43) Date of publication of application: 02.10.2019
(73) Proprietor: BENEDETTI, Federica, 50127 Firenze (IT)
(72) Inventor: FALSINI, Martino, 50142 Firenze (IT)
(74) Representative: Firmati, Leonardo
(86) International application number: PCT/IB2017/057248
(87) International publication number: WO 2018/096437

(56) References cited:
- WO-A1-95/15582
- US-A1- 2008 041 441

## Description

### Technical field

This invention relates in general to the field of solar collection technologies and in detail relates to a photovoltaic module. The document WO95/15582A is a closely related prior art.

### Background art

There are prior art devices comprising photovoltaic modules with concentrators having reflective surfaces - formed by a mirror - having grooves with a V-shaped profile placed alongside each other. This type of photovoltaic modules is known in the jargon of the trade with the term 'V-grooved'.

Alongside the grooves with a V-shaped profile may be placed flat reflective surfaces - or flat mirrors - inclined with a direction opposite to that of the V-shaped grooves.

These flat reflective surfaces may also be, if necessary, joined together uninterruptedly, thus forming a set of surfaces forming a system for collecting the electromagnetic solar radiation, which is diverted towards the sides of the system itself where photovoltaic cells are positioned that are designed for converting the solar radiation received into electricity. Thus, the photovoltaic module comprises a sequence of photovoltaic cells alternated with systems for collecting electromagnetic solar radiation.

The elements of the photovoltaic module are positioned under a material which constitutes a front covering of the photovoltaic module. This material, in order to guarantee the correct solar exposure of the photovoltaic cells, is transparent to solar radiation.

Moreover, this material guarantees the covering of the sensitive elements of the photovoltaic module, including the electric circuits which extend from the photovoltaic cells, which are therefore are covered by extraneous agents.

Moreover, the covering material is also a functional part and thus forms part of the system for collecting and deflecting the solar radiation towards the photovoltaic cells, given that the radiation reflected by the reflective surfaces will strike the interface between the front material and the air outside at an angle of incidence greater than the critical angle, being thus again reflected by a total internal reflection, thereby reaching the photovoltaic cell.

Prior art patent documents US2009250093 and EP 1732141 both illustrate photovoltaic modules containing solar concentrators as described above.

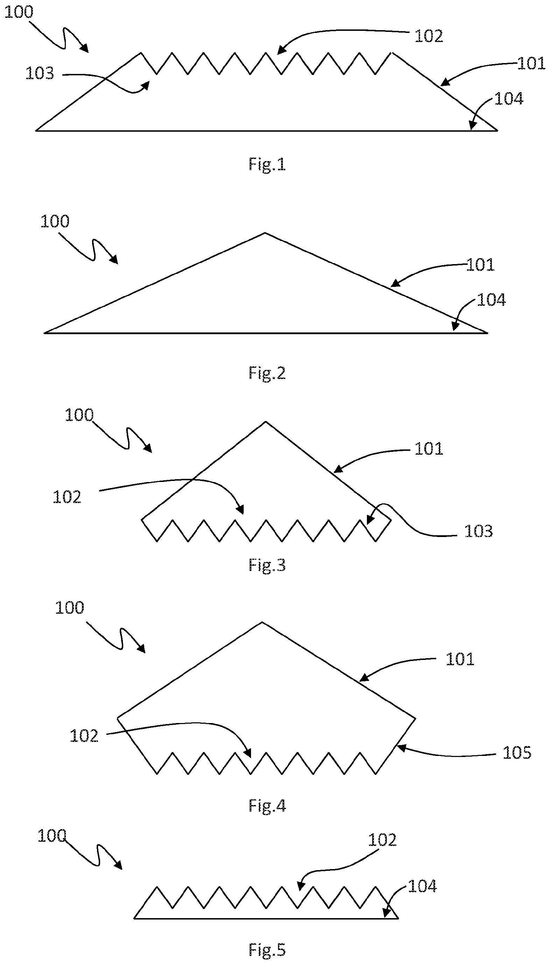

The patent document EP1732141 indicates an embodiment wherein there is no reflective surface with V-shaped grooves, but only flat reflective surfaces inclined in a direction opposite to each other. This embodiment is shown in Figures 3 and 5 of the document.

The photovoltaic modules described in the prior art, including those of the above-mentioned documents, suffer from certain drawbacks.

The patent document US200925093 does not describe a solution for connecting the photovoltaic cells with elements which connect them passing through the underlying regions to the mirror surfaces which are interposed between adjacent photovoltaic cells.

In patent document US2009250093 the mirror surfaces may be interposed between the cells only on two sides of the latter. Patent document US2009250093 indicates a technology which is limited in terms of the total surface of the reflective surfaces in proportion to the surface of the cells. Consequently, the technology according to the patent US2009250093 has a limitation in the economic savings which can be obtained with the use of these mirror surfaces.

Moreover, the photovoltaic modules described in patent document EP 1732141 do not allow the use of front and rear sheets of the casing which have flat inner surfaces.

This means that in the construction of panels according to the type described in patent document EP 1732141, it is necessary to make use of multiple folds both of the encapsulating material and of the interconnecting elements of the photovoltaic cells, namely in the crossing of the underlying regions of the reflective surfaces.

This differs with respect to the common and efficient production technique, in which the aim is to guarantee an inner flat profile of the plates, to provide maximum duration and reliability of the photovoltaic module.

In the documents described above, the interconnecting elements between the photovoltaic cells are defined as "ribbons" or "wires". In the prior art construction techniques these interconnecting elements are welded on the front and rear surface of each photovoltaic cell and in the known construction technique they often, with the inner edge of their fold which is located on one of the edges of the cell to which it belongs, exert a pressure force on the edge of the cell.

This means that micro fissures or fractures are created from the start of the assembly inside the cell, which often over time result in the complete breakage of the photovoltaic cell into various fragments.

It is also known that the photovoltaic cells are so sensitive to vibrations that they can break even with only with the action of wind on the photovoltaic panel. Thus, the micro fissures caused by the above-mentioned edges lead to the reduction of the average life cycle of the photovoltaic cells.

The failure of the photovoltaic cells is associated with so-called "hot spot" phenomena until reaching the concrete risk of short circuit.

Moreover, the interconnecting elements between the photovoltaic cells are also subjected, in use, to thermal expansion; this thermal expansion is well known to cause faults in the photovoltaic panels, and in particular it may cause slight deformations.

In the embodiment shown in Figure 5 in patent document EP 1732141 there is not a solution with a thin encapsulating material of constant thickness. It may be inferred, on the other hand, how this must occupy the entire volume interposed between the material of the flat rear covering plate of the casing of the photovoltaic module and the transparent front cover, also comprising the volume of the triangular grooves with which this is shaped.

This solution again differs relative to the prior art, which is currently adopted in the construction of photovoltaic modules, which aims to guarantee an inner profile with plates of a constant cross-section, in order to guarantee the maximum reliability of the photovoltaic module and, consequently, ensure both the maximum efficiency and the maximum duration of the life cycle. More specifically, the presence of the cavity in the triangular grooves reduces the reliability of lamination of the photovoltaic module, as it hinders the removal of the air between the plates, causing the permanence of possible bubbles also after the lamination has ended. This, in particular, may occur due both to the inability of the encapsulating material to occupy the entire space of the cavities, as it is obstructed by the shape with a variable thickness which makes it at least difficult to create a homogeneous pressure of the encapsulating material in the entire volume, and due to the entrapment of a mass of air by the encapsulating material before the mass of air can escape from the casing.

It is known that the presence of air inside the photovoltaic module is one of the main causes of a of poor quality lamination.

Moreover, the lamination quality also depends on a series of characterising parameters, including the duration or the temperature, which are optimised according to the thickness of the space occupied by the encapsulating material which is, preferably, homogeneous, otherwise the parameters will be optimum for a certain thickness and not for the others. Moreover, the variable thickness of the space occupied by the encapsulating material causes the presence of edges on the inner profile of the front plate, due to the triangular grooves. These elements could cause a weakening of the sheet of encapsulating material when this is heated to a temperature suitable for the lamination production process; the weakening may cause the failure of the sheet, or in any case result in weakening of the welds. An imperfect lamination is prone to let enter at least water vapour into the module, and this leads to a rapid deterioration of the same, reducing significantly the useful life.

Moreover, the filling of the entire volume of the triangular grooves only with encapsulating material forces the use of a very thick encapsulating material, which is much greater than the thickness which the prior art recommends as optimal in terms of reliability provided to the photovoltaic module. In effect, the encapsulating material does not have a capacity of insulation from water vapour, which the front and rear plates of the casing do have. Thus the greater the thickness of the encapsulating material, the greater is the quantity of moisture which is able to penetrate the module. Another drawback of the prior art modules is due to the impossibility of applying, on such a greater thickness, a sealer which touches the front and rear plates in front of the encapsulating material at the outside of the casing, for isolating it completely from the outside environment.

In any case, the greater the thickness of the encapsulating material, the greater is also the overall cost of the module and its lamination process, because, as well as the cost of the encapsulating material, a large quantity of encapsulating material also results in a greater energy cost for the production process.

The aim of the invention is therefore to provide a photovoltaic module which overcomes the above-mentioned drawbacks.

### Summary of the Invention

The aim of this invention is to provide a photovoltaic module comprising at least one photovoltaic cell, at least one electrical interconnecting connection and at least one solar deflector the solar deflector comprising a groove for containing at least the one electrical interconnecting connection or the photovoltaic cell, the groove having a main direction of extension and comprising at least bilateral containment means of the electrical interconnecting connection or the photovoltaic cell along a direction transversal to the main direction of extension.

According to another aim of the invention, the containment means are at least trilateral containment means.

According to another aim of the invention, the groove of the solar deflector has a transversal cross section relative to the main open polygonal direction of extension.

According to another aim of the invention, the groove of the solar deflector has a transversal cross section relative to the main closed polygonal direction of extension.

According to another aim of the invention, the groove of the solar deflector has a transversal cross section relative to the main open circular polygonal direction of extension.

According to another aim of the invention, the solar deflector has a transversal cross section relative to the main closed circular polygonal direction of extension.

According to another aim of this invention, the solar deflector is positioned close to at least one side of the photovoltaic cell, the solar deflector has a main longitudinal direction of extension and a polygonal transversal cross section, the cross section comprising at least two inclined sides facing each other having opposite inclinations and at least one side shaped with a saw tooth profile.

According to another aim of this invention, the solar deflector is at least partly coated by a reflective material.

According to another aim of this invention the module is of the two-faced type and the photovoltaic cell is sensitive on both its planar faces.

According to another aim of this invention, the module also comprises at least two electrically conductive surfaces which must be mutually insulated from each other and the solar deflector also comprising an electrically conductive reflective surface and being positioned in contact with the two electrically conductive surfaces, the solar deflector also comprising an electrically insulating interposing layer for insulating the two surfaces.

### Description of the drawings

The invention will now be described by way of a preferred, non-limiting embodiment with reference to the accompanying drawings, in which:
- Figure 1 is a cross section of a first embodiment of a solar deflector according to the invention;
- Figure 2 is a cross section of a second embodiment of a solar deflector according to the invention;
- Figure 3 is a cross section of a third embodiment of a solar deflector according to the invention;
- Figure 4 is a cross section of a fourth embodiment of a solar deflector according to the invention;
- Figure 5 is a cross section of a fifth embodiment of a solar deflector according to the invention;
- Figure 6 is a cross section of part of a photovoltaic module using the deflector according to the invention;
- Figure 7 is a plan view of part of the photovoltaic module according to the invention;
- Figure 8 illustrates a detail of a perspective view of a possible junction point of a plurality of solar cells in the photovoltaic module according to the invention;

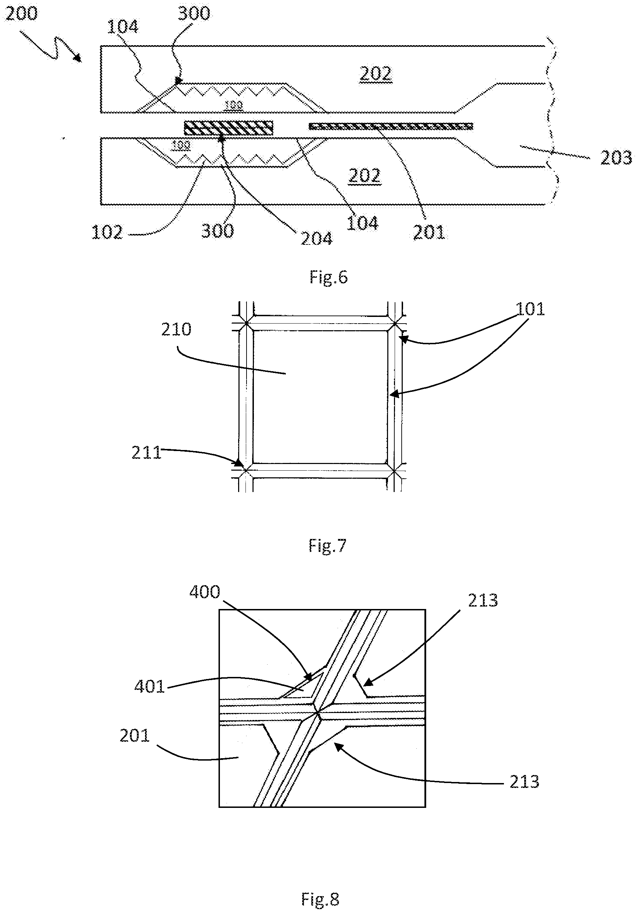

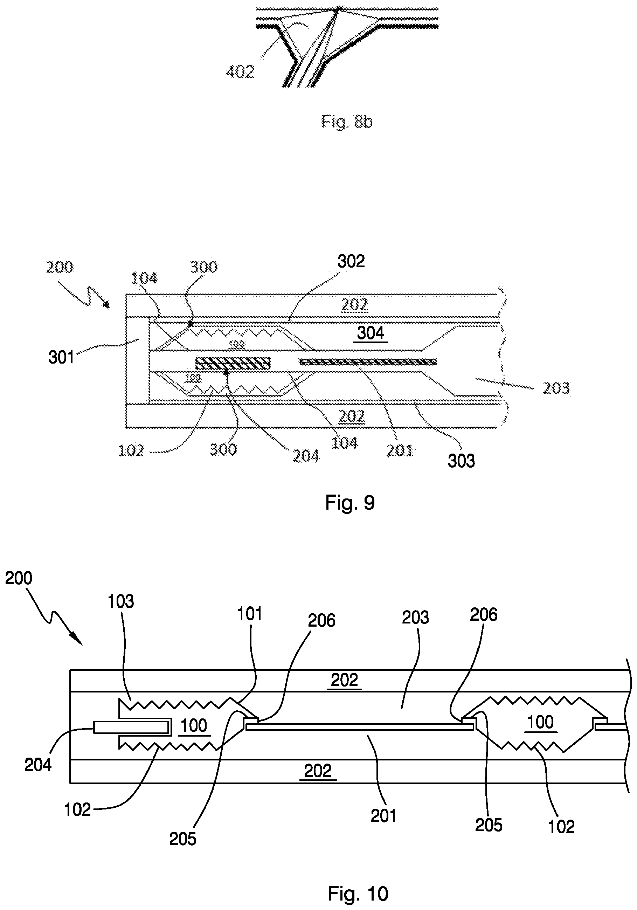

- Figure 8 illustrates a detail of a perspective view of a further possible junction point of a plurality of solar cells in the photovoltaic module according to the invention;
- Figure 9 illustrates a detail of a cross section of an alternative embodiment of the invention;
- Figure 10 illustrates a detail of a cross section of a further embodiment of the invention;

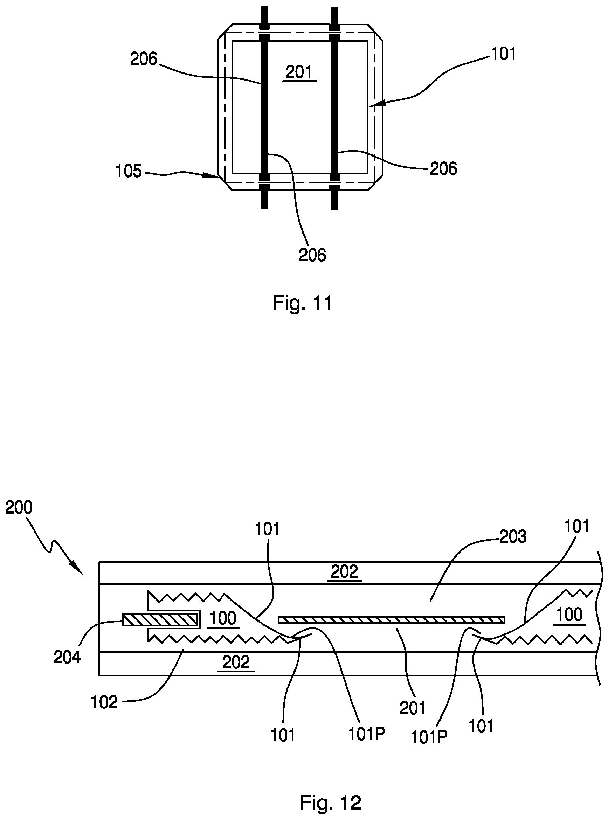

- Figure 11 illustrates a top view of a possible embodiment of the solution of Figure 10 and
- Figure 12 illustrates a detail of a cross section of a further alternative embodiment of the invention.

### Detailed description.

With reference to Figures 1 to 5, the numeral 100 denotes in its entirety a solar deflector.

In the first embodiment illustrated in Figure 1, the solar deflector 100 comprises a first pair of reflective surfaces 101 oriented in opposite directions to each other, between which there is interposed a sequence 102 of reflective surfaces 103 positioned in the form of a triangle. Substantially, the sequence 102 of reflective surfaces 103 extends along a direction of maximum extension at right angles to the direction which is identified by the thickness of the photovoltaic panel, and also comprises a sequence of reflective surfaces 103 joined at one end of them alternatively upper and lower and oriented to each other in opposite directions and symmetrical about an axis at right angles to the direction of maximum extension identified by them, without interposing further walls between them, namely parallel to the direction of maximum extension, thus being in direct connection.

It should also be noted that although the accompanying drawings illustrate reflective surfaces 103 symmetrical to each other, the symmetry must not be construed in such a way as limiting the scope of the invention, since both the length and the slope of the reflective surfaces may vary without thereby departing from the protective scope of the appended claims.

The reflective surfaces 103 of the sequence 102 have a significantly smaller extension than the extension of the reflective surfaces 101, which, however, each have a relative first end joined with the sequence 102 of reflective surfaces 103 and a second end opposite the above-mentioned first end which is, on the other hand, joined with the bottom wall 104.

The embodiment of the collector illustrated in Figure 1 may also be made in such a way that the deflector 100 is formed by transparent material, since in this way the solar radiation may enter in the deflector 100 starting from the bottom wall 104 and then reflect on the reflective elements 101 and/or 103 from the side inside the deflector 100.

Moreover, it is preferable that, the refraction index of the material of the deflator 100 is less than or equal to that of the covering layer 202 and of the adhesive or glue used for joining the deflector 100 on the groove of the covering layer 202.

Lastly, the choice of the material of the deflector 100 must necessarily fall on a material which does not significantly change the relative mechanical and optical properties, namely transparency, at the high temperatures which can be reached during the following lamination process or the same operating life cycle of the photovoltaic module.

Moreover, it is necessary to emphasise that the use of transparent material also allows the use of the deflector 100 in the embodiment shown in Figure 1 in a two-face module.

In the second embodiment of the deflector 100 according to the invention, illustrated in Figure 2, on the other hand, the reflective surfaces 101 are oriented in opposite directions relative to each other, but not there is not the sequence 102 of reflective surfaces 103 which, on the other hand, is present in the first embodiment. Consequently, each of the two reflective surfaces 101 has a relative first end joined at an angular point with the first end of the reflective surface 101 opposite to it, and a second end which joins with a planar bottom wall 104 forming, the latter, a rear face of the solar deflector module.

The embodiment of the collector illustrated in Figure 2 may also be made in such a way that the deflector 100 is formed by transparent material, since in this way the solar radiation may enter in the deflector 100 starting from the bottom wall 104 and then reflect on the reflective elements 101 and/or 103 from the side inside the deflector 100.

Moreover, it is preferable that, the refraction index of the material of the deflator 100 is less than or equal to that of the covering layer 202 and of the adhesive or glue used for joining the deflector 100 on the groove of the covering layer 202.

Lastly, the choice of the material of the deflector 100 must necessarily fall on a material which does not significantly change the relative mechanical and optical properties, namely transparency, at the high temperatures which can be reached during the following lamination process or the same operating life cycle of the photovoltaic module.

Moreover, it is necessary to emphasise that the use of transparent material also allows the use of the deflector 100 in the embodiment shown in Figure 2 in a two-face module.

In the third embodiment of the deflector 100 according to this invention, illustrated in Figure 3, in a similar fashion to the embodiment illustrated in Figure 2, the reflective surfaces 101 are oriented in the opposite directions to each other, and each has a first end joined with the first end of the other reflective surface 101 so as to form an angle at the top which is convex and a second end which, on the other hand, is joined with a sequence 102 of reflective surfaces 103 which thus lie at a height lower and which correspond in use to the rear face of the photovoltaic module.

A fourth embodiment of the deflector 100 according to the invention is illustrated in Figure 4. The fourth embodiment is similar to the third embodiment described above. The fourth embodiment also has reflective surfaces 101 which are oriented in the opposite directions to each other, and each has a first end joined with the first end of the other reflective surface 101 so as to form an angle at the top which is convex and a second end which is joined with a first end of respective connecting surfaces 105, oriented in an oblique direction relative to the two main reflective surfaces 101, so as to form acute inner angles. The second end of the connecting surfaces 105 has reached the sequence 102 of reflective surfaces 103 lying at a lower height and which corresponds in use to the rear face of the photovoltaic module.

The third and fourth embodiment described above each have the presence of reflective surfaces on both the front and rear faces; this feature is important since these collectors are designed for a use inside a two-faced photovoltaic module, that is to say, characterised by cells which are able to collect the solar radiation on both faces and having front and rear covering plates which are both transparent.

Lastly, the fifth embodiment of the collector according to the invention is shown in Figure 5. In this configuration, the sequence 102 of reflective surfaces 103 is joined with a planar bottom wall 104 substantially lying in contact with the angular points formed by the joints of the reflective surfaces.

The embodiment of the collector illustrated in Figure 5 may also be made in an overturned manner, that is to say, with the bottom wall 104 glued or welded in the groove of the covering layer 202. In this case, it is necessary that the deflector 100 is formed by transparent material, since in this way the solar radiation may enter in the deflector 100 starting from the bottom wall 104 and then reflect on the reflective elements 101 and/or 103 from the side inside the deflector 100.

Moreover, it is preferable that, the refraction index of the material of the deflator 100 is less than or equal to that of the covering layer 202 and of the adhesive or glue used for joining the deflector 100 on the groove of the covering layer 202.

Lastly, the choice of the material of the deflector 100 must necessarily fall on a material which does not significantly change the relative mechanical and optical properties, namely transparency, at the high temperatures which can be reached during the following lamination process or the same operating life cycle of the photovoltaic module.

Moreover, it is necessary to emphasise that the use of transparent material also allows the use of the deflector 100 in the embodiment shown in Figure 5 in a two-face module.

According to a preferred embodiment, the collectors described here are preferably made from thermoplastic material and namely by means of an injection moulding process or other techniques for processing plastic material known to an expert in the trade. The choice of material for the collector can also fall on a material which does not modify over time the relative characteristics and physical properties, namely mechanical, in particular at the temperatures which can be reached during the lamination or during the life cycle of the solar collector when installed in the module.

The reflective surfaces are, on the other hand, made with a highly reflective material on the entire solar radiation spectrum, at least in the visible and infrared spectrum; preferably, the reflective surfaces are made of silver or alternately of aluminium as a first alternative - less expensive but also with a lower performance - or gold, as a further possible theoretical alternative, which although valid from a technical point of view, has a significantly higher cost.

The making of the reflective surfaces is preferably performed by means of a prior art technique known as "sputtering", even though other known techniques can be used.

As illustrated in Figure 6, a photovoltaic module 200 comprises an alternating sequence of adjacent photovoltaic cells 201, collected between two deflectors 100 opposite each other, which in the case of the photovoltaic module 200 shown by way of example in Figure 6 correspond each to a deflector like that of the first embodiment illustrated in Figure 1. Each deflector 100 is enclosed inside a planar covering layer 202 which is also transparent to the solar radiation. The planar covering layer 202 forms a front and rear cover of the photovoltaic module 200. Between the first and the second covering layer 202 is a gap layer 203 in which are positioned both the photovoltaic cells 201 and the busbar 204, that is, an electrical interconnection element. An encapsulating material is positioned in the layer of gap 203 which isolates electrically the two covering layers 202, and also isolates the photovoltaic cells 201 and the busbar 204.

The planar covering layer 202 is also functional in the photovoltaic module 200 since the radiation reflected by the reflective surfaces will strike the interface between the front planar covering layer 202 and the air with an angle of incidence greater than the critical angle, being thus again reflected by a total internal reflection, until reaching at the end a photovoltaic cell.

Each covering layer 202 may accommodate inside its grooves reflective elements designed to collect the solar radiation which passes through the covering layer. For this reason, the grooves with which each covering layer 202 is made are shaped with a shape or profile matching, or in any case compatible with the collector installed. Although not illustrated in Figure 6, the covering layer 202 may be made with the relative inner surface, that is to say, in contact with the gap layer 203 and also containing the grooves, modelled according to a texture, of a suitably selected type, as a function of contrast with inner reflections to the interface between the covering layer 202 and the materials with which it is in contact on the inner surface, including, for example, the encapsulating material and/or the adhesive or glue 300.

Although not illustrated in Figure 6, the deflectors 100 may, if necessary, have a portion which do not lie inside the grooves present in the covering layer 202 but which extends in the gap layer 203, in which the encapsulating material is also located.

In that case, the deflectors 100 may have on the bottom wall 104 grooves designed to accommodate any interconnecting elements between the underlying photovoltaic cells, in technical jargon defined as "wires" or "ribbons", preferably not diverting the path as made in the case where the deflectors 100 lie exclusively inside the grooves present in the covering layer 202.

Again, as illustrated in Figure 6, it is possible to make two-faced photovoltaic modules using front 202 and/or rear 202 covering layers which accommodate in their grooves deflector elements according to any of the five embodiments illustrated in Figures 1 to 5.

It is also possible to make a photovoltaic module, not illustrated, with traditional photovoltaic cells 201 of the single-faced type, that is to say, which are able to collect the solar radiation only on one face, which is typically the front face. In this case, the rear covering layer may be flat or replaced with a different element, even not transparent.

In the process for making the photovoltaic module 200 according to this invention, the deflectors 100 are joined to the covering layer 202 at the respective groove by an adhesive or glue 300 or any other welding technique which allows the joining of the two above-mentioned parts without damaging by thermal pulse. The adhesive or glue are transparent to the solar radiation at least in the visible spectrum and in the infrared spectrum. Moreover, the refraction index of the adhesive or glue is preferably equal to or less than that of the covering layer 202.

The adhesive or glue 300 used for the joining the deflector 100 on the groove of the covering layer 202 must also be able to saturate completely the space between the reflective elements and the groove to which they are welded, in order to achieve an optical coupling without irregularities or defects between the surfaces welded. Lastly, the choice of the adhesive must necessarily fall on a material which does not significantly change the relative mechanical and optical properties, namely transparency, at the high temperatures which can be reached during the following lamination process or the same operating life cycle of the photovoltaic module.

In the operating configuration described in Figure 6, it is also possible to check that the plates on the outer edge do not have reflective elements which, on the contrary, are held further from the edge, inside the casing of the module, to a sufficient extent to protect them from infiltration of water vapour and extraneous agents.

Thus, externally, the photovoltaic module 100 according to the invention appears identical to the traditional photovoltaic modules without deflectors. As already briefly mentioned above, the busbar 204 and, more in general, all the electrical interconnecting elements with the photovoltaic cells 201 are preferably located at the sides of the photovoltaic module 100 and preferably enclosed in the electrically insulating layer of the encapsulating material which is present behind the reflective elements, both in the two-faced module shown in Figure 6 and, if necessary, in the single-faced module not illustrated in the accompanying drawings.

The configuration with electrical interconnecting elements behind the reflective elements makes it possible to collect the solar radiation also in the area occupied by the electrical interconnecting elements, which is not possible in traditional photovoltaic modules without concentration elements, advantageously allowing an extension of the area for collecting the solar radiation to be obtained, under equal conditions of total surface of the photovoltaic module, which thereby increases the overall efficiency.

The grooves un along the entirety of the covering layers 202. Thus, if the grooves were present on all four the sides of the cells, each groove would cross other grooves at the four edges which each cell forms by means of its edge. The reflective elements may also adopt the shape of their penetration, that is, occupying the entire inner space. An example is shown in Figure 7. In this drawing it can be seen how it is possible to make all the reflective elements 101 to be placed in the grooves of a covering layer 202 with a single grille-shaped element, or make, equally, a reflective element of length equal to the length of the groove in which the reflective element will be housed. The reflective element can cross the others in a fitting 211 as shown in Figure 7, forming a single reflective element which extends along the entire length of the groove regardless of the number of crossings to be made with other reflective elements, forming a chequerboard surface comprising square sections 210.

Lastly, Figure 8a shows a solution to adapt the deflectors 100 which cross in the presence of photovoltaic cells 201 of the pseudo squared type. The pseudo squared photovoltaic cells not are square, but have bevelled corners 213. Figure 8a schematically indicates a first solution wherein a flat mirror 400 occupies the area 401 in the edge of the reflective elements crossed which is not occupied by the pseudo squared type cell.

A further possible solution, shown in Figure 8b, consists in extending the reflective elements with an inclined mirror 402 which occupies the area in which in the edge which is not occupied by the pseudo type squared cell.

Figure 9 shows a construction variant of all the embodiments already presented which comprises the division of the covering layer 202 into two separate elements with specific and different functions.

The embodiment illustrated in Figure 9 comprises a covering layer 202 with the surfaces 302 totally flat, such as, for example and without limiting the scope of the invention, a common solar glass "float", used in conventional photovoltaic modules without concentration elements. Below the flat covering layer 202 is placed an inner element 304 which has grooves similar to those provided in the embodiments presented, for example made of a thermoplastic with high transmittance of the solar radiation in the spectrum used by the photovoltaic cell, for example PMMA or optical grade polycarbonate. The two flat covering layer elements 202 and the underlying inner element 304 with grooves are glued/welded together by prior art techniques, for example but without limiting the scope of the invention, by means of a laminating process by means of a sheet of encapsulating material (for example, sheet of EVA commonly used for laminating photovoltaic modules) located in the gap between the two elements, if necessary also with a single lamination process of the entire photovoltaic module and its casing. The inner element 304 with grooves may, if necessary, not extend up to the perimeter of the covering elements 202 so as to leave on the edge 301 of the photovoltaic module the perimeter space in which to locate an insulation from external agents, of a type already known and commonly used in the making of traditional photovoltaic modules, in such a way as to allow a further, if necessary, degree of insulation and protection of all the elements inside the covering elements 202. The embodiment illustrated in Figure 9 illustrates an alternative production embodiment of the embodiment illustrated in Figure 6, but it is clear that this variant can be applied to all the embodiments presented. The variant embodiment described is useful in particular in order to make the most of the specific performance of different materials in relation to the various requirements for making the covering layer of the module above on the outer face and of the grooves below on the inner face; if a single element is adopted which performs both the functions it will be necessary to the use a material which makes compromises between the requirements specified by both the functions performed. If, on the other hand, it is possible to make two separate elements one can select for each of the two elements the material with the best performance characteristics in relation to the specific function performed for the covering layer 202 or the grooved inner element 304. In particular, the mechanical strength characteristics and the barrier against the infiltration of external agents are important for the covering layer 202, in addition to the stability over time of these requirements, associated with a good transmittance of the solar radiation in the spectrum used by the photovoltaic cell and the capacity to maintain over time a reduced roughness of the outer surface even though subjected to external agents. These requirements are best achieved, for example but without limiting the scope of the invention, by the common solar glass "float" and by, for example, PMMA, in particular for the main function of the barrier against infiltration of external agents. On the other hand, of particular importance for the grooved inner element 304 is the possibility of making the grooves with the smallest dimensional tolerances possible and with the maximum freedom of design choice in relation to the shape and size of the individual grooves located in the same grooved inner element 304. These requirements are better achieved, for example, by PMMA (which can be worked in any shape of groove with extremely small tolerances with the known processes of working thermoplastics, for example, injection moulding), rather than, for example, the common solar glass (subjected to the making of grooves as "patterned glass" or "rolled glass").

Although not illustrated in Figure 9, the inner element 304 may be made with the relative inner surface, that is to say, in contact with the gap layer 203 and also containing the grooves, modelled according to a texture, of a suitably selected type, as a function of contrast with inner reflections to the interface between the inner element 304 and the materials with which it is in contact on the inner surface, including, for example, the encapsulating material and/or the adhesive or glue 300.

Figure 10 shows a construction variant of all the embodiments already presented which comprises deflectors 100, in other embodiments with respect to those formed in Figures 1 to 5, located not inside the grooves present in the covering layer element 202 or inner element 304, but directly between the photovoltaic cells 201 in the gap layer 203.

The embodiment illustrated in Figure 10 comprises making all the reflective elements 101 and/or 103 to be located on a single element in the form of a grille, or to make, equally, more elements which can cross over each other with a fitting 211 as already shown in Figure 7, making, lastly, a single assembled element which delineates the same shape and function as the grille.

With the embodiment illustrated in Figure 10 the use is therefore not necessary of a covering layer 202 equipped with grooves, so the inner profile can therefore be flat. Moreover, the deflectors 100, being located in the gap layer 203, in turn with a flat inner profile, may be made with a shape which makes it possible to lie alongside the photovoltaic cells 201 without creating on their surface any pressure or mechanical force: in particular, since the deflectors 100 have a thickness greater than the other elements inside the covering layers 202 it is possible, through their thickness, to determine substantially both the thickness of the gap layer 203, summing the thickness of the encapsulating material, and the position inside the thickness of the gap layer 203 of the volumes of the deflectors 100, thereby ensuring that the heights of these spaces not collide with those of the spaces occupied by the photovoltaic cells 201, in their positioning inside of the gap layer 203. In short, there is no significant mechanical interference between the deflectors 100 and photovoltaic cells 201, with the latter not having stresses which are different to or greater than what there would be in the conventional photovoltaic modules without deflectors.

The grille, containing all the reflective elements 101 and/or 103 constituting the deflectors 100, can therefore be located in the spaces located between the photovoltaic cells 201, in the process for assembling the photovoltaic module, preferably after the positioning of the photovoltaic cells interconnected, if necessary, in series or parallel.

The embodiment illustrated in Figure 10 comprises the presence of reflective elements 101 and/or 103 on both the front and rear faces of the deflector elements 100; this feature is important since these collectors are designed, preferably, for a use inside a two-faced photovoltaic module, that is to say, characterised by cells which are able to collect the solar radiation on both the faces and having front and rear covering plates which are both transparent.

The embodiment illustrated in Figure 10 comprises two-faced deflector elements 100 substantially formed by the joining of two deflectors 100 according to the embodiment of Figure 1. Although not illustrated, it is possible to also use with the embodiment illustrated in Figure 10 the embodiments of the deflector elements 100 substantially formed by the joining of two deflectors in the other embodiments shown in Figures 2 and 5. Although not illustrated, it is possible to also use with the embodiment illustrated in Figure 10 the embodiments of the deflector elements 100 shown in Figures 3 and 4.

Although not illustrated in Figure 10, embodiments may be used which comprise the presence of deflector elements 100, formed by transparent material, since in this way the solar radiation may enter in the deflector 100 starting from the bottom wall 104 and then reflect on the reflective elements 101 and/or 103 from the side inside the deflector 100.

Moreover, it is preferable that, the refraction index of the material of the deflator 100 is less than or equal to that of the covering layer 202 and of the adhesive or glue used for joining the deflector 100 on the groove of the covering layer 202.

The choice of the material of the deflector 100 must necessarily fall on a material which does not significantly change the relative mechanical and optical properties, namely transparency, at the high temperatures which can be reached during the following lamination process or the same operating life cycle of the photovoltaic module.

Moreover, it is necessary to emphasise that the use of transparent material also allows the use of the deflector 100 in the embodiment shown in Figure 10 in a two-face module.

Although not illustrated in Figure 10, embodiments may be used which comprise the presence of deflector elements 100, preferably according to the embodiments of Figures 1 to 5, only on one face; these collectors are designed preferably for a use inside a photovoltaic module characterised by photovoltaic cells which are able to collect the solar radiation only on one face.

The embodiment illustrated in Figure 10 comprises several volumes 205 of deflectors 100 superposed on the photovoltaic cells 201. This superposing 205 is to avoid the creation of regions of discontinuity, between the deflectors 100 and the photovoltaic cells 201, which are passed through by the solar radiation without it being possible to carry out the collection. With this superposing 205 it is therefore possible to avoid these discontinuities, for example if there are possible dimensional variations which may occur between elements of the same type inside the photovoltaic module, in particular between the deflectors 100 or between the photovoltaic cells 201, and in the case of possible variations in their respective distances of spatial location. The superposing 205 may be performed only on one face of the deflector 100, for example only on the front face, as illustrated in Figure 10, or on both the front and rear faces. The superposing 205 of the deflectors 100 on the photovoltaic cells 201 may also be used to superpose the deflectors 100 on any electric current conduction elements 204 and/or 206 inside the cell, and/or for interconnecting between several photovoltaic cells; these types of elements, for example also called in the technical jargon "finger", "busbar" 204, "ribbon" or "wire" 206, due to the screening which they cause in front of the active regions of the photovoltaic cell, that is to say, the regions of the photovoltaic cell which are capable of absorbing and converting the solar radiation, so that part of the solar radiation is not collected but is reflected outside the photovoltaic module. If the electric current conduction elements inside the cell and/or for interconnecting between several photovoltaic cells are subjected to the deflectors 100, the radiation incident in these regions will be collected from the deflectors 100 before reaching these elements without the occurrence of the failed collection described, advantageously allowing an extension of the area for collecting the solar radiation to be obtained under equal conditions of total surface area of the photovoltaic module, thus increasing the overall efficiency. Although not illustrated in Figure 10 is it possible to make the reflective elements 101 and/or 103 also on the faces of the deflectors 100 inside the overlapping 206, in such a way as to collect the solar radiation also in these inner regions, as a result of any exposure due to the dimensional and spatial location variations of the elements inside the photovoltaic module.

The embodiment illustrated in Figure 10 comprises several paces of the deflectors 100 superposed on the busbar 204 and more generally speaking on all the electrical interconnecting elements. If the busbar 204 and/or electrical interconnecting elements are located behind the deflectors 100 with respect to the incident radiation, this will be collected in these regions by the deflectors 100 before reaching the busbar 204 and/or electrical interconnecting elements without the occurrence of the failed collection, advantageously allowing an extension of the area for collecting the solar radiation to be obtained under equal conditions of total surface area of the photovoltaic module, thus increasing the overall efficiency. The embodiment illustrated in Figure 10 makes it necessary to adopt preventive measures to guarantee the electrical insulation between the front and rear surfaces of the photovoltaic cells 201 or between photovoltaic cells 201 adjacent to each other or between photovoltaic cells 201 and/or other elements of the module inside the gap layer 203, purely by way of example, and without limiting the scope of the invention, all the electrical interconnecting elements. It should be considered, in effect, that with the position of the deflectors 100 close to the photovoltaic cells 201 there might occur a direct contact between the elements, even though they are located in an electrical insulating material such as the encapsulating material. Due to the presence on the deflectors 100 of the reflective elements 101 and/or 103, possibly made with a metallic reflective material, in this case also electrically conductive, it is necessary to avoid, as mentioned, the occurrence in this way of unwanted and deleterious electrical contacts. For this purpose it will be sufficient to apply on the single deflector 100 the known techniques to make regions in which there are no reflective elements 101 and/or 103 comprising electrically conductive reflective material, so as to divide the single deflector 100 into various regions which are electrically insulated from each other, since the body of the deflector 100 is made from an electrically conductive material. The insulation can, for example, be achieved by known techniques of masking a region of the deflector 100 during the depositing on it of the reflective material constituting the reflective elements 101 and/or 103, or according to the prior art techniques, for example of laser scribing, for removing part of the reflective material after its placing on the deflector 100.

An alternative for achieving the same aim comprises depositing, using the known techniques, a layer of insulating material above at least a region of the reflective elements 101 and/or 103 consisting of electrically conductive reflective material. The insulating material may be transparent to solar radiation.

The embodiment illustrated in Figure 10 shows the possible making of reflective elements 103 which are different from each other in terms of size and/or direction located in a sequence 102 which is further from the covering layers 202 with respect to the minimum distance between these and the reflective elements 101 forming part of the deflector 100. This embodiment achieves a reduction in the extension of the region in which there is the smallest thickness of the encapsulating material located in the gap layer 203, achieving a greater strength of the welding made by the encapsulating material between the various components inside the photovoltaic module and the covering layers 202.

Figure 11 shows a construction variant of the embodiments already presented starting from Figure 10, comprising grooves in the deflector 100 designed to accommodate any interconnecting elements between the photovoltaic cells, in technical jargon referred to as "wires" or "ribbons" 206, preferably not diverting the relative path as in the traditional photovoltaic modules without deflectors. In this embodiment, the deflectors 100 can be placed alongside the photovoltaic cells 201 without creating on their surface any pressure or mechanical force. In short, there is no significant mechanical interference between the deflectors 100 and photovoltaic cells 201, with the latter not having stresses which are different to or greater than what there would be in the conventional photovoltaic modules without deflectors. Although not illustrated in Figure 11 it is possible, if necessary, to partly cover the accesses of the grooves on the surface of the deflector 100, at the top and laterally, by suitable shapes of the deflector element 100 which allow, each time according to the design application of the photovoltaic module, to optimise the deflection of the solar radiation caused by the presence of the grooves relative to a deflector 100 which does not have them.

Figure 11 shows a construction variant of the embodiments already presented starting from Figure 10, which comprises making of the deflectors 100 located not inside the grooves present in the covering layer element 202 or inner element 304, but directly between the photovoltaic cells 201 in the gap layer 203.

The embodiment illustrated in Figure 11 comprises making all the reflective elements 101 and/or 103 on an element 105 in the shape of a frame about a single photovoltaic cell 201, or to make, equally, more elements which can cross over each other with a fitting, making, lastly, a single assembled element which delineates the same shape and function as the frame of the single photovoltaic cell 201.

The frame 105, containing the reflective elements 101 and/or 103 constituting the deflectors 100, can therefore be located in the spaces located to the sides of the photovoltaic cell 201 on which it is located in the process for assembling the photovoltaic module, preferably after the positioning of the photovoltaic cells 201 interconnected, if necessary, in series or parallel. As in the embodiment illustrated in Figure 11, the frame may contain all the reflective elements 101 and/or 103 constituting the deflectors 100 relative to a spacing between adjacent cells, so that it follows that the deflectors 100 contained therein divert the solar radiation towards both cells adjacent to each area occupied by the frame and not only towards the cell surrounded by the frame 105; it follows that the frame 105 illustrated in Figure 11 is positioned not on all the cells 201 of a module but in an alternating fashion for every two cells of the same row. Although not illustrated in Figure 11, deflectors 100 are positioned on the edges of a photovoltaic module with a rectangular or square shape, also using a half frame in the shape of a "L" or as one piece with frames 105 adjacent as extensions thereof, which are drawn near to the sides facing the edge of the module of the photovoltaic cell 201 located on the edge which would otherwise not would have any deflector 100 on these sides.

The frame-like embodiment of the deflectors 100 is important because makes it possible to minimise the impact both of the possible dimensional variations which may occur between elements of the same type inside the photovoltaic module, in particular between deflectors 100 or between photovoltaic cells 201 and of the possible variations in their respective spatial location distances: making it possible to adapt the spatial location of each frame as a function of the actual spatial location of each photovoltaic cell 201, given by its installation as part of the process of assembling the photovoltaic module, eliminates the possibility of the dimensional variations, although permitted within a tolerance, given by a greater number of elements of a single element containing the deflectors 100, with respect to the dimensional variations permitted relative to a single photovoltaic cell 201 and to a single frame.

Figure 12 shows a construction variant of the embodiments already presented starting from Figure 10, comprising a deflector 100 preferably combined with a two-faced photovoltaic cell 201, where the reflective elements 101 of the front face of the deflector 100 reflect the solar radiation both on the front face and on the rear of the photovoltaic cell 201. As illustrated in Figure 12, the deflector 100 may also be made in a two-faced version, with reflective elements 101 and/or 103 also on the rear face, in accordance with the embodiments included in the inventive concept of this invention.

In accordance with an embodiment covered in the inventive concept of this invention, the reflective element 101 may have at least one portion of the surface with an open broken line cross section.

In accordance with a different embodiment covered in the inventive concept of this invention, illustrated in the detail of Figure 12, the reflective element 101 may have at least one portion of the surface with a curved cross section. In other words, the mirror portion of the reflective surface advantageously has a parabolic shape.

The portion of reflective element 101, whether it is made with the shape of an open broken line or curved or parabolic, is made with a mould, and is then positioned, preferably in such a way that the rays which are reflected, at least with the same direction as those accepted by the respective deflector 100 by means of the reflective element 101 in its entirety, are in any case deflected to the photovoltaic cells 201. The portion of reflective element 101 advantageously allows the distance to be reduced between the reflective element 101 and the photovoltaic cell 201 closest to it.

In accordance with an embodiment covered in the inventive concept of this invention, the reflective element 101 may have at least one portion of the surface with an open broken line cross section, sloping away from the remaining portions of the reflective element 101.

In accordance with a different embodiment covered in the inventive concept of this invention, illustrated in the detail of Figure 12, the reflective element 101 may have at least one portion of the surface with a curved cross section, sloping away from the remaining portions of the reflective element 101. In other words, the mirror portion of the reflective surface advantageously has a parabolic shape, sloping away from the remaining portions of the reflective element 101.

The portion of reflective element 101, whether it is made with the shape of an open broken line or curved or parabolic, is made with a mould, and is then positioned, preferably in such a way that the rays which are reflected, at least with the same direction as those accepted by the respective deflector 100 by means of the reflective element 101 in its entirety, are in any case deflected to the photovoltaic cells 201. The portion of reflective element 101 advantageously allows the distance to be reduced between the reflective element 101 and the photovoltaic cell 201 closest to it, preferably at least to an extent so as to reflect all the rays, at least coming from the front covering layer 202, which pass across the distance with a direction with an angle of incidence on the covering layers 202 less than critical angle at the interface between the covering layers 202 and the outside of the module, in such a way that it is not possible to achieve a total internal reflection.

In accordance with an embodiment covered in the inventive concept of this invention, the sheet of encapsulating material which is placed in the gap layer 203, at the time of assembly of the photovoltaic module which precedes the step of processing the lamination, may have a thickness and matching profile and/or in any case compatible with the other elements inside the gap layer 203, so that during the steps prior to the completion of the lamination process no forces or mechanical stresses are transmitted to the internal elements such as to deform or damage them.

The advantages of the invention as described are clear in light of the above description. The photovoltaic module made in this way, having a flat profile, provides a thinner thickness of the encapsulating material, which is also useful for overcoming the drawbacks of the modules described in the prior art solutions.

The photovoltaic module thus created has elements for electrical connection with the photovoltaic cells 201 which are without interconnection folds, with a reduction of the mechanical forces which intervene on the photovoltaic cell and on the mirror surfaces adjacent to it. With the construction of the photovoltaic module as described, it is also possible to extend the photovoltaic cells until reaching the reflective surfaces so as to achieve the complete collection of the solar radiation which reaches the module also from a different direction relative to the normal of the outer surface.

Moreover, the making of flat reflective surfaces which are not in contact with the front or rear layer advantageously allows the making of the layer by means of injection moulding, with a better surface roughness which consequently results in a greater efficiency of collection of the solar radiation incident on the module.

Lastly, through the making of the module by a layer of plastic material, and not in glass, precisely through the smaller tolerances which are present in the processing of the plastic relative to the glass, it is possible to guarantee a finished product which allows a more uniform irradiation of all the photovoltaic cells 201, to guarantee a greater overall efficiency in the energy transfer.

With regard to the prior art solutions shown in patent document US2009250093, in Figure 3, it is possible to reduce the number of empty spaces filled with adhesive, which represent a zone of failed collection of solar radiation that in this document represents a negative impact on the efficiency of the overall collection.

Finally, it is clear that the solar panel described above may be added to or adapted in ways obvious to experts in the trade without thereby departing from the protective scope of the appended claims.

## Claims

1. A photovoltaic module (200) comprising at least one photovoltaic cell (201), at least one electrical interconnecting connection (206, 204) and at least one solar deflector (100) the solar deflector (100) comprising a groove for containing at least the one electrical interconnecting connection (206, 204) or the photovoltaic cell (201), the groove having a main direction of extension and comprising at least bilateral containment means of the electrical interconnecting connection (206, 204) or the photovoltaic cell (201) along a direction transversal to the main direction of extension.

2. The photovoltaic module (200) according to claim 1, wherein the containment means are at least trilateral containment means.

3. The photovoltaic module (200) according to claim 1 or 2, wherein the groove of the solar deflector (100) has a transversal cross section relative to the main open polygonal direction of extension.

4. The photovoltaic module (200) according to claim 1 or 2, wherein the groove of the solar deflector (100) has a transversal cross section relative to the main closed polygonal direction of extension.

5. The photovoltaic module (200) according to claim 1 or 2, wherein the groove of the solar deflector (100) has a transversal cross section relative to the main open circular direction of extension.

6. The photovoltaic module (200) according to claim 1 or 2, wherein the groove of the solar deflector (100) has a transversal cross section relative to the main closed circular direction of extension.

7. The photovoltaic module (200) according to any one of the preceding claims, wherein the solar deflector (100) is positioned close to at least one side of the photovoltaic cell (201), the solar deflector (100) having a main longitudinal direction of extension and a polygonal transversal cross section, the cross section comprising at least two inclined sides facing each other having opposite inclinations and at least one side shaped with a saw tooth profile.

8. The photovoltaic module (200) according to any one of the preceding claims, wherein the solar deflector (100) is at least partly reflective.

9. The photovoltaic module (200) according to any one of the preceding claims, **characterised in that** it is a two-faced module and wherein the photovoltaic cell (201) is sensitive on both its planar faces.

10. The photovoltaic module (200) according to any one of the preceding claims, also comprising at least two electrically conductive surfaces which must be mutually insulated from each other and the solar deflector (100) also comprising an electrically conductive reflective surface and being positioned in contact with the two electrically conductive surfaces, the solar deflector (100) also comprising an electrically insulating interposing layer for insulating the two surfaces.

## Patentansprüche

1. Fotovoltaisches Modul (200), umfassend mindestens eine fotovoltaische Zelle (201), mindestens einen elektrischen Verbindungsanschluss (206, 204) und mindestens einen Solardeflektor (100), wobei der Solardeflektor (100) eine Nut zum Enthalten von mindestens dem einen elektrischen Verbindungsanschluss (206, 204) oder der fotovoltaischen Zelle (201), wobei die Nut eine Hauptausdehnungsrichtung aufweist und mindestens bilaterale Aufnahmemittel des elektrischen Verbindungsanschlusses (206, 204) oder der fotovoltaischen Zelle (201) entlang einer Richtung quer zur Hauptausdehnungsrichtung umfasst.

2. Fotovoltaisches Modul (200) nach Anspruch 1, wobei die Aufnahmemittel mindestens trilaterale Aufnahmemittel sind.

3. Fotovoltaisches Modul (200) nach Anspruch 1 oder 2, wobei die Nut des Solardeflektors (100) einen Querschnitt relativ zur offenen polygonalen Hauptausdehnungsrichtung aufweist.

4. Fotovoltaisches Modul (200) nach Anspruch 1 oder 2, wobei die Nut des Solardeflektors (100) einen Querschnitt relativ zur geschlossenen polygonalen Hauptausdehnungsrichtung aufweist.

5. Fotovoltaisches Modul (200) nach Anspruch 1 oder 2, wobei die Nut des Solardeflektors (100) einen Querschnitt relativ zur offenen kreisförmigen Hauptausdehnungsrichtung aufweist.

6. Fotovoltaisches Modul (200) nach Anspruch 1 oder 2, wobei die Nut des Solardeflektors (100) einen Querschnitt relativ zur geschlossenen kreisförmigen Hauptausdehnungsrichtung aufweist.

7. Fotovoltaisches Modul (200) nach einem der vorhergehenden Ansprüche, wobei der Solardeflektor (100) nahe an mindestens einer Seite der fotovoltaischen Zelle (201) positioniert ist, wobei der Solardeflektor (100) eine Hauptlängsausdehnungsrichtung und einen polygonalen Querschnitt aufweist, wobei der Querschnitt mindestens zwei einander zugewandte geneigte Seiten mit entgegengesetzten Neigungen und mindestens eine mit einem Sägezahnprofil geformte Seite umfasst.

8. Fotovoltaisches Modul (200) nach einem der vorhergehenden Ansprüche, wobei der Solardeflektor (100) zumindest teilweise reflektierend ist.

9. Fotovoltaisches Modul (200) nach einem der vorhergehenden Ansprüche, **dadurch gekennzeichnet, dass** es ein zweiseitiges Modul ist und wobei die fotovoltaische Zelle (201) auf ihre beiden ebenen Flächen empfindlich ist.

10. Fotovoltaisches Modul (200) nach einem der vorhergehenden Ansprüche, umfassend ebenfalls mindestens zwei elektrisch leitende Oberflächen, die voneinander isoliert sein müssen, und der Solardeflektor (100) umfasst ebenfalls eine elektrisch leitende reflektierende Oberfläche und ist in Kontakt mit den zwei elektrisch leitenden Oberflächen positioniert, wobei der Solardeflektor (100) auch eine elektrisch isolierende Zwischenschicht zum Isolieren der beiden Oberflächen umfasst.

## Revendications

1. Module photovoltaïque (200) comprenant au moins une cellule photovoltaïque (201), au moins une connexion d'interconnexion (206, 204) électrique et au moins un déflecteur solaire (100), le déflecteur solaire (100) comprenant une gorge servant à contenir au moins l'une connexion d'interconnexion (206, 204) électrique ou la cellule photovoltaïque (201), la gorge comportant une direction principale d'extension et comprenant au moins des moyens de contenance bilatéraux de la connexion d'interconnexion (206, 204) électrique ou de la cellule photovoltaïque (201) le long d'une direction transversale à la direction d'extension principale.

2. Module photovoltaïque (200) selon la revendication 1, dans lequel les moyens de contenance sont au moins des moyens de contenance trilatéraux.

3. Module photovoltaïque (200) selon la revendication 1 ou 2, dans lequel la gorge du déflecteur solaire (100) comporte une section transversale par rapport à la direction polygonale ouverte principale d'extension.

4. Module photovoltaïque (200) selon la revendication 1 ou 2, dans lequel la gorge du déflecteur solaire (100) comporte une section transversale par rapport à la direction polygonale fermée principale d'extension.

5. Module photovoltaïque (200) selon la revendication 1 ou 2, dans lequel la gorge du déflecteur solaire (100) comporte une section transversale par rapport à la direction circulaire ouverte principale d'extension.

6. Module photovoltaïque (200) selon la revendication 1 ou 2, dans lequel la gorge du déflecteur solaire (100) comporte une section transversale par rapport à la direction circulaire fermée principale d'extension.

7. Module photovoltaïque (200) selon l'une quelconque des revendications précédentes, dans lequel le déflecteur solaire (100) est positionné à proximité d'au moins un côté de la cellule photovoltaïque (201), le déflecteur solaire (100) ayant une direction longitudinale principale d'extension et une section transversale polygonale, la section transversale comprenant au moins deux côtés inclinés se faisant face comportant des inclinaisons opposées et au moins un côté façonné à profil en dents de scie.

8. Module photovoltaïque (200) selon l'une quelconque des revendications précédentes, dans lequel le déflecteur solaire (100) est au moins partiellement réfléchissant.

9. Module photovoltaïque (200) selon l'une quelconque des revendications précédentes, **caractérisé en ce qu'**il s'agit d'un module biface et dans lequel la cellule photovoltaïque (201) est sensible sur ses deux faces planes.

10. Module photovoltaïque (200) selon l'une quelconque des revendications précédentes, comprenant aussi au moins deux surfaces électriquement conductrices devant être mutuellement isolées l'une de l'autre et le déflecteur solaire (100) comprenant aussi une surface réfléchissante électriquement conductrice et étant positionné en contact avec les deux surfaces électriquement conductrices, le déflecteur solaire (100) comprenant également une couche d'interposition électriquement isolante servant à isoler les deux surfaces.
